Europäisches Patentamt

European Patent Office

Office européen des brevets

(19)

(11) Veröffentlichungsnummer: **0 205 835 B1**

(12) **EUROPÄISCHE PATENTSCHRIFT**

(45) Veröffentlichungstag der Patentschrift: 07.08.91

(51) Int. Cl.5: **H03H 17/04**

(21) Anmeldenummer: 86106041.6

(22) Anmeldetag: 02.05.86

(54) **Digitales Rekursiv-Filter.**

(30) Priorität: 22.06.85 DE 3522412

(43) Veröffentlichungstag der Anmeldung:
30.12.86 Patentblatt 86/52

(45) Bekanntmachung des Hinweises auf die
Patenterteilung:
07.08.91 Patentblatt 91/32

(84) Benannte Vertragsstaaten:
AT CH DE FR GB LI NL

(56) Entgegenhaltungen:
EP-A- 0 135 606

1978 IEEE INTERNATIONAL SYMPOSIUM ON
CIRCUITS AND SYSTEMS PROCEEDINGS,
New York, 17.-19. Mai 1978, Seiten 1023-1027,
IEEE, New York, US; D. MITRA: "Summary of
results on controlled rounding arithmetics,
for direct form digital filters, that eliminate
all self-sustained oscillations"

IEEE PROCEEDINGS SECTIONS A a I, Band
130, Nr. 3 Teil G, Juni 1983, Seiten 69-77, Old
Woking, Surrey, GB; L.E. TURNER et al.:
"Elimination of constant-input limit cycles in
recursive digital filters using a generalised
minimum norm"

IEEE TRANSACTIONS ON CIRCUITS AND SY-
STEMS, Band Cas.27, Nr. 1, Januar 1980,
IEEE, New York, US; L.E. TURNER et al.:
"Elimination of granularity and overflow limit
cycles in minimum norm recursive digital
filters"

(73) Patentinhaber: ANT Nachrichtentechnik GmbH
Gerberstrasse 33
W-7150 Backnang(DE)

(72) Erfinder: Göckler, Heinz, Dipl.-Ing.
Elbinger Strasse 52
W-7150 Backnang(DE)

(74) Vertreter: Wiechmann, Manfred, Dipl.-Ing.
ANT Nachrichtentechnik GmbH Gerberstrasse 33 Postfach 11 20
W-7150 Backnang(DE)

EP 0 205 835 B1

EP 0 205 835 B1

## Beschreibung

Die Erfindung betrifft ein digitales Rekursiv-Filter gemäß Oberbegriff eines der Ansprüche 1 bis 4.

Solche Filter sind bekannt und beispielsweise beschrieben in dem Aufsatz "Elimination of Granularity and Overflow Limit Cycles in Minimum Norm Recursive Digital Filters" von Turner und Bruton in IEEE Transactions on circuits and systems, Vol. CAS-27, No. 1, January 1980, Seiten 50 bis 53.

In einem rekursiven Digital-Filter treten als Folge der endlichen Signalwortlänge 2 Arten von Nichtlinearitäten auf. Die 1. Art hat ihre Ursache in den Rundungs- und/oder Schneideoperationen, die wegen der Granularität der Signale im Anschluß an gewisse arithmetische Operationen auszuführen sind. Die 2. Art wird dadurch hervorgerufen, daß Ergebnisse arithmetischer Operationen den Zahlenbereich überschreiten, der durch die jeweilige Signalwortlänge vorgegeben ist.

Man spricht in diesem Zusammenhang auch von sogenannten Überlauf-Nichtlinearitäten.

Als Folge der Nichtlinearitäten können bekanntlich parasitäre Schwingungen auftreten, durch welche die Funktionsfähigkeit eines Digitalfilters stark beeinträchtigt werden kann. Gemäß der Ursache ihres Entstehens lassen sich diese Schwingungen in Granularitäts- bzw. Grenzzyklus- und Überlauf-Schwingungen unterteilen.

Die zuletzt genannten Schwingungen müssen unter allen Umständen vermieden werden, da ihre Amplituden in der Größenordnung der Signale liegen. In vielen Fällen wird man auch an einer Unterdrückung der Granularität- bzw. Grenzzyklus-Schwingungen interessiert sein, zumal ihre Leistungen ebenfalls sehr hoch und ihre Spektren nur auf wenige Frequenzen konzentriert sein können.

Durch die deutsche Patentschrift 24 18 923 sind digitale Rechnerfilter bekannt geworden, bei welchen die genannten Grenzzyklus-Schwingungen wirksam unterbunden werden, wenn bestimmte Bedingungen für diese digitalen Rechnerfilter eingehalten werden. Zu diesen Bedingungen gehört, daß die von jedem Schaltungsabschnitt des Filters absorbierte Pseudo-Leistung

$$P(t) = \sum_{\nu=1}^{n} G_\nu \left[ a_\nu^2(t) - b_\nu^2(t) \right]$$

gleich oder größer ist als der jenige Wert der Pseudo-Leistung, der sich ergibt, wenn unter Fortlassung der Rundungs- bzw. Schneideschaltungen bzw. der Überlaufkorrektur die arithmetischen Operationen exakt ausgeführt werden, wobei $\nu$ die Nummer der Tore (1 bis n),

$a_\nu(t)$ die Eingangsgröße zum Zeitpunkt t im $\nu$.Tor,

$b_\nu(t)$ die Ausgangsgröße zum Zeitpunkt t im $\nu$.Tor und

$G_\nu$ eine dem $\nu$. Tor zugeordnete positive Größe sind.

Ein solches n-Tor wird pseudopassiv genannt.

Als inkrementalpseudopassiv werden Filter bezeichnet, bei denen die von jedem Schaltungsabschnitt absorbierte inkrementale Pseudoleistung gleich oder größer ist als derjenige Wert der inkrementalen Pseudoleistung, der sich ergibt, wenn unter Fortlassung der Überlaufkorrektur die arithmetischen Operationen ausgeführt werden.

Die inkrementale Pseudoleistung errechnet sich aus der vorhin angegebenen Pseudoleistung, indem man die Eingangs- bzw. die Ausgangsgrößen $a_\nu(t)$ bzw. $b_\nu(t)$ durch die Inkremente $\Delta a_\rho(t)$ bzw $\Delta b_\rho(t)$ ersetzt.

Wenn diese Bedingung eingehalten wird, so ist das digitale System frei von Überlauf-Schwingungen und gesteigert antwortstabil. Antwortstabil heißt, daß eine durch einen Überlauf hervorgerufene Störung auch bei nicht verschwindender Erregung stets abklingt, sofern unter idealen linearen Bedingungen Überläufe nur vorübergehend auftreten.

Gesteigerte Antwortstabilität bedeutet, daß permanent auftretende geringfügige Überläufe auch nur geringfügige Störungen des Ausgangssignals zur Folge haben.

Der Erfindung lag die folgende Aufgabe zugrunde, die eingangs genannte Zustandsvariablen-Filterstruktur bei wirtschaftlich vertretbarem Aufwand so zu realisieren, daß die Bedingung inkrementale Pseudopassivität und die dadurch implizierte Antwortstabilität erfüllt ist.

Diese Aufgabe wird gelöst durch die Merkmale der Ansprüche 1 bis 4.

Die Vorteile des erfindungsgemäßen digitalen Rekursivfilters liegen darin, daß damit erstmalig eine explizite, nicht nur theoretische, schaltungsmäßige Lösung angegeben wird, mit der die Bedingung inkrementale Pseudopassivität und die dadurch implizierte Antwortstabilität mit wirtschaftlich vertretbarem Aufwand erreicht wird.

Es folgt nun die Beschreibung der Erfindung anhand der Figuren.

Die Figur 1a zeigt eine Zustandsvariablen-Filter-Blockstruktur 2. Ordnung und die zugehörigen Figuren 1b

2

und 1c die Bestimmung des Signalkorrekturterms für Fest- bzw. Gleitkomma-Arithmetik.

Die Figur 2a gibt eine alternative inkremental pseudopassive Realisierung einer Zustandsvariablen-Filter-Blockstruktur 2. Ordnung wieder. In entsprechender Weise zeigen die Figuren 2b und 2c die Bestimmung der Signalkorrekturterme in Form eines Zustandsdiagramms.

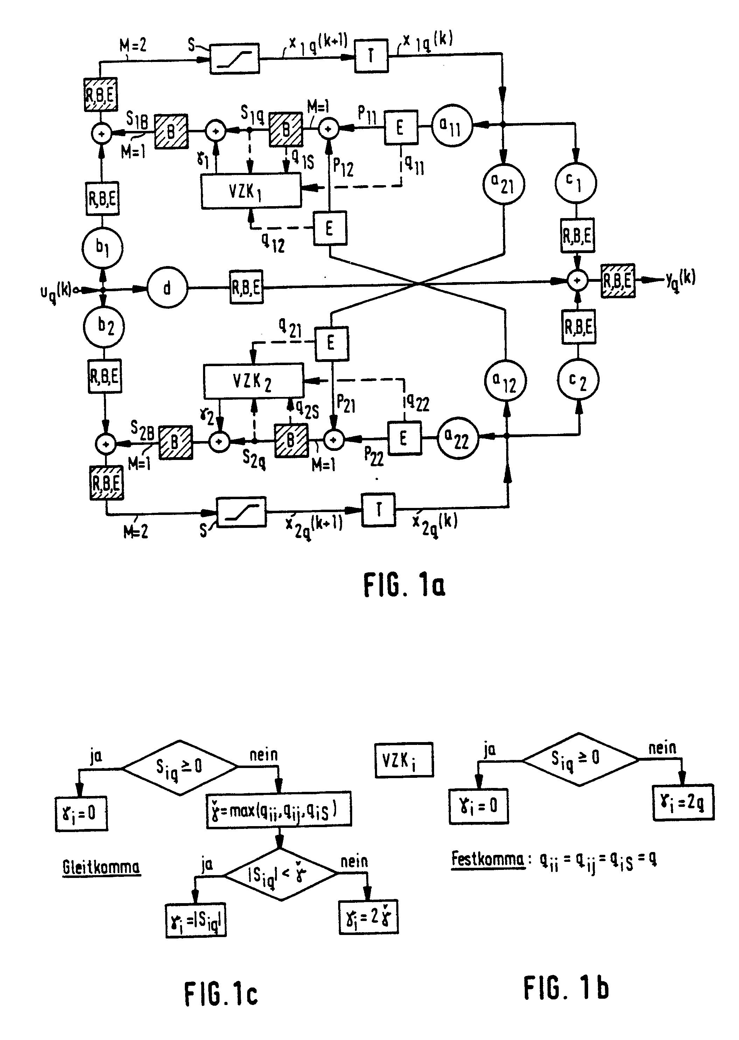

Die Zustandsvariablen-Filter-Blockstruktur 2. Ordnung gemäß Figur 1a enthält einen Transversalzweig und 2 Rekursivzweige mit jeweils einem Verzögerungsglied T, dessen Ausgangssignal in einer ersten Schleife auf seinen eigenen Eingang und in einer zweiten Schleife jeweils auf den Eingang des anderen Verzögerungsgliedes rückgeführt wird. In der ersten Schleife wird das Ausgangssignal $x1q(k)$ mit a11 bewertet, dann einer Zweierkomplement-Schneideoperation E unterzogen. Anschließend erfolgt die Vereinigung mit dem Ausgangssignal des anderen Verzögerungsgliedes, welches Signal mit a12 bewertet und einer Zweierkomplement-Schneideoperation E unterzogen wird. Das Summensignal S1b wird zu dem mit b1 bewerteten Eingangssignal $uq(k)$, welches anschließend einer Rundungs- bzw. Schneideoperation unterzogen wird, addiert, dann einer Sättigungskennlinie (Begrenzer S) unterzogen und sodann als Eingangssignal $x1q(k+1)$ des Verzögerungsgliedes T verwendet. In entsprechender Weise sind die 1. und 2. Schleife für das 2. Verzögerungsglied aufgebaut. Die beiden Ausgangssignale $x1q(k)$ und $x2q(k)$ der Verzögerungsglieder T werden mit c1 bzw. c2 bewertet und anschließend einer Rundungs- oder Schneideoperation unterzogen.

Mittels eines Summierers werden beide Signale und das Ausgangssignal des Transversalzweiges summiert und anschließend einer Rundungs- bzw. Schneideoperation zum Ausgangssignal $yq(k)$ unterzogen.

Die erfindungsgemäße Signalkorrektur VZK erfolgt gemäß Figur 1a jeweils nach der Vereinigung der beiden Rekursivsignale Pii und Pij. Das vereinigte Signal Siq wird auf Werte kleiner Null untersucht. Ist das der Fall, so wird zum Signal Siq der Korrekturterm $\gamma i = 2q$ hinzuaddiert. q ist die Quantisierungsstufe, welche bei Realisierung des Filters in Festkomma-Arithmetik einheitlich ist (Fig. 1b).

Selbstverständlich kann die Signalkorrektur VZKi auch an anderer Stelle des Rekursivzweiges vorgenommen werden, beispielsweise vor oder hinter dem Begrenzer S oder dem Verzögerungsglied T.

Wird die Filterstruktur gemäß Figur 1a in Gleitkomma-Arithmetik ausgeführt, so müssen zusätzlich die Operationen des Rundens R, des Betragschneidens B oder des Zweierkomplementschneidens E gemäß der schraffierten Blöcke durchgeführt werden. Diese Operationen haben hinter jeder Addition bzw. Summierung zu erfolgen, wobei die Wortlängenverkürzung nach der Addition der beiden Rekursivsignale Pii und Pij jeweils die Betragsschneideoperation B zu sein hat. Die Vornahme der Signalkorrektur ist der Figur 1c zu entnehmen. Gemäß Figur 1a wird das betragsgeschnittene Signal Siq auf negative Werte untersucht. Ist dies der Fall, so wird als Korrekturterm $\check{y}$ der größte Wert max der Quantisierungsstufen qii, qij und qiS der rückgeführten Signale Pii, Pij bzw. des untersuchten und eventuell zu korrigierenden Signals Siq genommen. Gemäß Figur 1c müßten jedoch 2 Fälle unterschieden werden, eine Korrektur gemäß Festkomma-Arithmetik erfolgt, wenn der Betrag des untersuchten Signals größer oder gleich dem Korrekturterm $\check{y}$ ist. Im anderen Fall wird dem Signal Siq sein Betrag zugefügt, d.h. auf Null gesetzt.

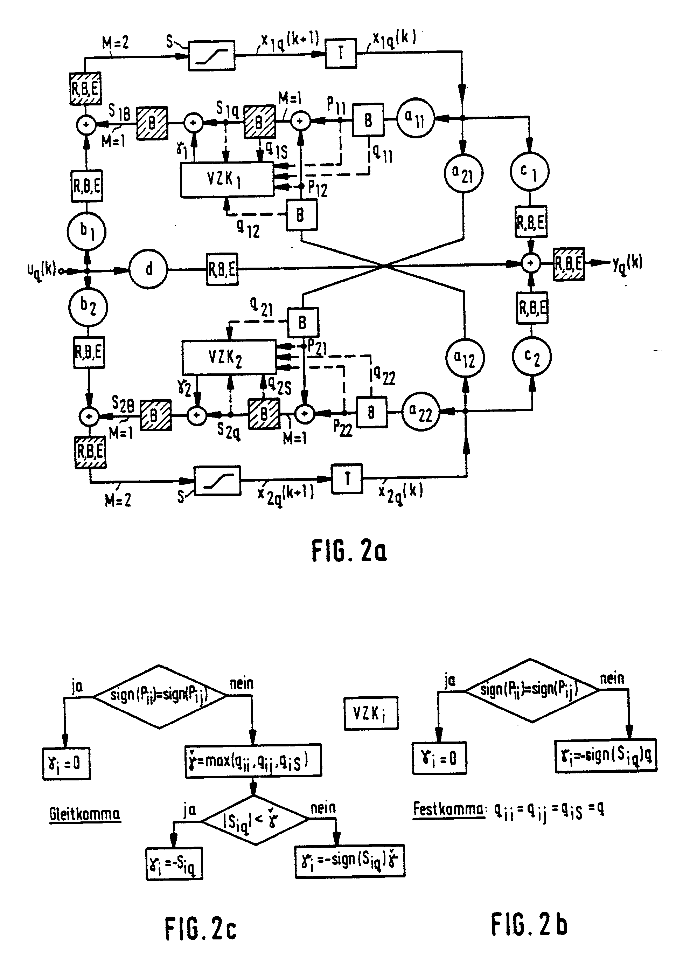

Die Struktur der Figur 2a entspricht derjenigen nach Figur 1a, einziger Unterschied ist, daß nach den Bewertungen der Rekursivschleifen-Signale jeweils nicht eine Zweierkomplementschneideoperation sondern eine Betragsschneideoperation B erfolgt. Die Signalkorrektur wird ebenfalls etwas anders durchgeführt als nach Figuren 1b und 1c. Es werden nämlich die Vorzeichen der zu addierenden ersten und zweiten Rekursivschleifen-Signale Pii und Pij miteinander verglichen (Fig. 2b), wobei im Gleichheitsfalle keine Signalkorrektur erfolgt und im Falle der Ungleichheit bei Realisierung mit Festkomma-Arithmetik der Korrekturterm $\gamma i = -\mathrm{sign}(Siq) \cdot q$ addiert wird, d.h. also die einheitliche Quantisierungsstufe q mit gegenüber dem zu korrigierenden Signal Siq invertiertem Vorzeichen addiert wird.

Die Signalkorrektur im Falle der Ausführung mit Gleitkomma-Arithmetik erfolgt gemäß Figur 2c. Im Falle der Ungleichheit der Vorzeichen der beiden Rekursivschleifen-Signale wird als Korrekturterm $\check{y}$ der größte Wert der Quantisierungsstufen dieser Signale bzw. des zu untersuchenden und gegebenenfalls zu korrigierenden Summensignals Siq genommen. Anschließend erfolgt eine weitere Untersuchung, nämlich die, ob der Betrag des Summensignales kleiner als der Korrekturterm $\check{y}$ ist. Ist das der Fall, dann wird das Signal auf Null gesetzt, im anderen Falle wie bei Festkomma-Arithmetik der Korrekturterm $\check{y}$ mit gegenüber dem zu korrigierenden Signal Siq invertierten Vorzeichen addiert.

## Patentansprüche

1. Digitales Rekursiv-Filter in Zustands-Raum-Struktur, wobei das mit b1 und b2 bewertete Eingangssignal $u(k)$ zwei Verzögerungsgliedern zugeführt wird, deren Ausgangssignale mit der Bewertung a11 bzw. a22 jeweils auf ihren Eingang rückgeführt sind und mit den Bewertungen a21 bzw. a12 jeweils auf den Eingang des anderen Verzögerungsgliedes rückgeführt sind und mit c1 bzw. c2 bewertet zum Ausgangssignal y(k) zusammengefaßt sind (Filter-Block zweiter Ordnung), mit vorgegebener Signalwortlänge, dadurch gekennzeichnet, daß nach der Bewertung mit a11, a12, a21 und a22 die Signale jeweils der Operation des Zweier-Komplement-Endschneidens (E) und nach jeder anderen Bewertung einer Schneide- oder Rundungsoperation (R, B, E) unterzogen werden,

daß das Ein- (Xiq(k + 1)) oder Ausgangssignal (xiq(k)) der Verzögerungsglieder (T jeweils einer Sättigungskennlinie (Begrenzer S) unterzogen wird und

daß das Ein- oder Ausgangssignal der Verzögerungsglieder (T) oder der Begrenzer (S) oder die auf den Eingang der

Verzögerungsglieder rückgeführten Signale (Siq) jeweils einer Signalkorrektur (VZKi) unterworfen werden, indem bei negativem Signal (Siq<0) diesem 2 Quantisierungsstufen (q) hinzuaddiert werden (Figur 1).

2. Digitales Rekursiv-Filter nach Anspruch 1 in Gleitkomma-Arithmetik, dadurch gekennzeichnet, daß bei negativem Signal (Siq<0) diesem 2 Quantisierungsstufen mit dem höchsten Wert (max (qii, qij, qis)) aus den 3 Ein- bzw. Ausgangssignalen des letzten im Signalweg zurückliegenden Addierers bzw. des die beiden rückgeführten Signale (Pii, Pij) zusammenfassenden Addierers hinzugefügt werden, wenn das Signal (Siq) betragsmäßig diese beiden Quantisierungsstufen nicht unterschreitet, oder das Signal (Sig) auf Null gesetzt wird, wenn es betragsmäßig diese beiden Quantisierungsstufen unterschreitet, und daß in allen anderen Fällen die Signalkorrektur unterbleibt (Figur 1).

3. Digitales Rekursiv-Filter in Zustands-Raum-Struktur, wobei das mit b1 und b2 bewertete Eingangssignal u(k) zwei Verzögerungsgliedern zugeführt wird, deren Ausgangssignale mit der Bewertung a11 bzw. a22 jeweils auf ihren Eingang rückgeführt sind und mit den Bewertungen a21 bzw. a12 jeweils auf den Eingang des anderen Verzögerungsgliedes rückgeführt sind und mit c1 und c2 bewertet zum Ausgangssignal y(k) zusammengefaßt sind (Filter-Block zweiter Ordnung), mit vorgegebener Signalwortlänge, dadurch gekennzeichnet, daß nach der Bewertung mit a11, a12, a21 und a22 die Signale jeweils der Operation des Betragsschneidens (B) und nach jeder anderen Bewertung einer Schneide- oder Rundungsoperation (R, B E) unterzogen werden,

daß das Ein- (Xiq(k + 1)) oder Ausgangssignal (Xiq(k)) der Verzögerungsgleider (T) jeweils einer Sättigungskennlinie (Begrenzer S) unterzogen wird und

daß das Ein- oder Ausgangssignal der Verzögerungsglieder oder der Begrenzer (S) oder die auf den Eingang der Verzögerungsglieder rückgeführten Signale (Siq) jeweils einer Signalkorrektur (VZKi) unterzogen werden, wobei ein Vorzeichenvergleich zwischen den beiden auf den Eingang jedes Verzögerungsgliedes rückgeführten Signale (Pii, Pij) durchgeführt wird und wobei bei Ungleichheit dem rückgeführten Signal (Siq) eine Quantisierungsstufe (q) mit dem gegenüber diesem Signal invertierten Vorzeichen (-sign(Siq)) hinzuaddiert wird, und daß sonst eine Signalkorrektur unterbleibt (Figur 2).

4. Digitales Rekursiv-Filter nach Anspruch 3 in Gleitkomma-Arithmetik, dadurch gekennzeichnet, daß bei Ungleichheit dem rückgeführten Signal (Siq) die höchste Quantisierungsstufe (max. (qii, qij, qis)) der 3 Ein- bzw. Ausgangssignale (Pii, Pij, Siq) des letzten im Signalweg zurückliegenden bzw. des die Rückführungssignale zusammenfassenden Addierers mit invertiertem Vorzeichen (-sign(siq)) hinzuaddiert wird, wenn es betragsmäßig diese Quantisierungsstufe nicht unterschreitet, und es auf Null gesetzt wird, wenn es diese unterschreitet (Figur 2).

## Claims

1. Digital recursive filter in phase space structure, wherein the input signal u(k) is weighted by b1 and b2 and is fed to two delay members, the output signals of which are each fed back with the weighting a11 and a22 to their respective inputs and with the weighting by a21 and a12 to the input of the respective other delay member and are combined, weighted by c1 and c2 respectively, into the output signal y(k) (filter block of second order) of preset word length, characterised thereby, that after the weighting by a11, a12, a21 and a22, the signals are each subjected to the operations of the complement-of-2 end cutting (E) and to a cutting or rounding operation (R, B, E) after every other weighting, that the input signal (Xiq(k + 1)) or the output signal (Xiq(k)) of the delay members (T) are each subjected to a respective saturation characteristic (limiter S) and that the input signal or the output signal of the delay members (T) or of the limiters (S) or the signals (Slq) fed back to the input of the delay members are each subjected to a respective signal correction (VZKi), in that in the case of a negative signal (Siq <0), 2 quantising steps (q) are added thereto (Figure 1).

4

2. Digital recursive filter according to claim 1 in floating decimal point arithmetic, characterised thereby, that in the case of a negative signal (Siq < 0), 2 quantising steps of the highest value (max (qii, qij, qis)) of the 3 input or output signals either of the last adder lying back in the signal path or of the adder combining both the fed-back signals (Pii, Pij) when the signal (Siq) in amount does not fall below both these quantising steps or the signal (Siq) is set to zero when it falls in amount below both these quantising steps and that the signal correction is omitted in all other cases (Figure 1).

3. Digital recursive filter in phase space structure, wherein the input signal u(k) is weighted by b1 and b2 and is fed to two delay members, the output signals of which are each fed back with the weighting a11 and a22 to their respective inputs and with the weightings by a21 and a12 to the input of the respective other delay member and are combined, weighted by c1 and c2 respectively, into the output signal y(k) (filter block of second order) of preset word length, characterised thereby, that after the weighting by a11, a12, a21 and a22, the signals are each subjected to the operation of the amount cutting (B) and to a cutting or rounding operative (R, B, E) after every other weighting, that the input signal (Xiq(k + 1)) or the output signal (Xiq(k)) of the delay members (T) are each subjected to a respective saturation characteristic (limiter S) and that the input signal or the output signal of the delay members (T) or of the limiters (S) or the signals (Siq) fed back to the input of the delay members are each subjected to a respective signal correction (VZKi), wherein a comparison of sign is performed between both the signals (ii, Pij) fed back to the input of each delay member and wherein, in the case of inequality, a quantising step (q) of inverted sign (-sign(Siq)) is added to the signal (Siq) fed back and that a signal correction is otherwise omitted (Figure 2).

4. Digital recursive filter according to claim 3 in floating decimal point arithmetic, characterised thereby, that the highest quanitising step (max (qii, qij, qis)) of the 3 input or output signals (Pii, Pij, Siq) either of the last adder lying back in the signal path or of the adder combining the fed back signals is addedd with inverted sign (-sign(Siq)) to the fed-back signal (Siq) when it does not fall in amount below this quantising step and the fed-back signal (Siq) is set to zero when it falls below this (Figure 2).

**Revendications**

1. Filtre récursif numérique en structure d'espace d'état, le signal d'entrée u(k) pondéré avec b1 et b2 étant amené à deux organes de retard dont les signaux de sortie sont rétrocouplés à chaque fois, avec la pondération respective a11, a22, à leur entrée et sont rétrocouplés, avec les pondérations respectives a21, a12, à chaque fois à l'entrée de l'autre organe de retard, et, étant pondérés avec c1, c2, sont regroupés pour former le signal de sortie y(k) (bloc-filtre du deuxième ordre), avec longueur de mot de signal prédéterminée, caractérisé par le fait qu'après la pondération avec a11, a12, a21 et a22 les signaux sont soumis à chaque fois à l'opération de coupure d'extrémité-complément de deux (E) et, après chaque autre pondération, sont soumis à une opération de coupure ou arrondi (R, B, E),
par le fait que le signal d'entrée (Xiq(k + 1)) ou le signal de sortie (Xiq(k)) des organes de retard (T) est soumis à chaque fois à une caractéristique de saturation (limiteur S), et
par le fait que le signal d'entrée ou de sortie des organes de retard (T) ou du limiteur (S), ou les signaux (Siq) rétrocouplés à l'entrée des organes de retard, sont soumis à chaque fois à une correction de signal (VZKi) selon laquelle, en cas de signal négatif (Siq < 0), on ajoute à celui-ci deux échelons de quantification (q) (figure 1).

2. Filtre récursif numérique selon revendication 1, en arithmétique en virgule flottante, caractérisé par le fait que, dans le cas ou le signal est négatif (Siq < 0) on lui ajoute deux échelons de quantification avec la valeur la plus grande (max(qii, qij, qis)) parmi les 3 signaux d'entrée ou de sortie du dernier additionneur en amont dans le trajet de signal ou, respectivement, de l'additionneur regroupant les deux signaux rétrocouplés (Pii, Pij), si le signal (Siq) n'est pas en valeur absolue Inférieur à ces deux échelons de quantification, ou le signal (Siq) est mis à zéro s'il est en valeur absolue inférieur à ces deux échelons de quantification, et par le fait que dans tous les autres cas la correction de signal n'a pas lieu (figure 1).

3. Filtre récursif numérique en structure d'espace d'état, le signal d'entrée u(k) pondéré avec b1 et b2 étant amené à deux organes de retard dont les signaux de sortie sont rétrocouplés à chaque fois, avec la pondération respective a11, a22, à leur entrée et sont rétrocouplés, avec les pondérations respectives a21, a12, à chaque fois à l'entrée de l'autre organe de retard, et, étant pondérés avec c1, c2, sont regroupés pour former le signal de sortie y(k) (bloc-filtre du deuxième ordre), avec longueur de mot de signal prédéterminée, caractérisé par le fait qu'après la pondération avec a11, a12, a21 et a22 les signaux sont soumis à chaque fois à l'opération (B) de coupure de valeur absolue et, après chaque autre pondération, sont soumis à une opération de coupure ou arrondi (R, B E), par le fait que le signal d'entrée (Xiq(k + 1)) ou de sortie (Xiq(k)) des organes de retard (T) est soumis à chaque fois à une caractéristique de saturation (limiteur S) et

par le fait que le signal d'entrée ou sortie des organes de retard ou du limiteur (S), ou les signaux (Siq) rétrocouplés à l'entrée des organes de retard, sont soumis à chaque fois à une correction de signal (VZKi), une comparaison de signe entre les deux signaux (Pii, Pij) rétrocouplés à l'entrée de chaque organe de retard étant effectuée, et, en cas d'inégalité, un échelon de quantification (q) avec le signe (-sign(Siq)) inversé par rapport à ce signal rétrocouplé (Siq) étant ajouté à ce dernier, et par le fait que dans l'autre cas il n'y a pas de correction de signal (figure 2).

4. Filtre récursif numérique selon revendication 3, en arithmétique en virgule flottante, caractérisé par le fait qu'en cas d'inégalité du signal rétrocouplé (Siq) on ajoute au signal rétrocouplé (Siq) l'échelon de quantification le plus élevé (max. (qii, qij, qis)) des trois signaux d'entrée ou de sortie (Pii, Pij, Siq) du dernier additionneur situé en amont dans le trajet de signal ou encore de l'additionneur regroupant les signaux de rétrocouplage, cette addition étant faite avec signe inversé (-sign(siq)), si la valeur absolue de ce signal n'est pas inférieure à cet échelon de quantification, et il est mis à zéro s'il est inférieur audit échelon (figure 2).

6

FIG. 1a

FIG.1c

FIG. 1b

FIG. 2a

FIG. 2c

FIG. 2 b